# EUROPEAN PATENT SPECIFICATION

(11) **EP 3 200 221 B1**
(45) Date of publication and mention of the grant of the patent: **05.05.2021**
(21) Application number: 15845065.0
(22) Date of filing: 23.07.2015
(51) Int. Cl.: H01L 21/677, H01L 21/673, H01L 21/54, G05D 7/06

(54) **PURGING DEVICE AND PURGING METHOD**
REINIGUNGSVORRICHTUNG UND REINIGUNGSVERFAHREN
DISPOSITIF ET PROCÉDÉ DE PURGE

(30) Priority: 25.09.2014 JP 2014195152
(43) Date of publication of application: 02.08.2017
(73) Proprietor: Murata Machinery, Ltd., Minami-ku, Kyoto 601-8326 (JP)
(72) Inventor: IWASAKI, Junji, Inuyama-shi Aichi 484-8502 (JP)
(74) Representative: Zimmermann, Tankred Klaus
(86) International application number: PCT/JP2015/071011
(87) International publication number: WO 2016/047260

(56) References cited:
- EP-A1- 2 546 173
- WO-A1-2012/160917
- WO-A1-2014/104895
- JP-A- 2012 114 406
- US-A1- 2008 240 892
- US-A1- 2010 290 873

## Description

### Field of the Invention

The invention relates to the purging of containers accommodating semiconductor wafers, etc.

### Background Art

In semiconductor factories, cassettes for accommodating semiconductor wafers are transferred by an overhead transfer system between load ports of processing equipment. As a temporary buffer between the overhead transfer system and the load ports, the applicant has proposed an apparatus comprising a local vehicle, its travelling rail, and a buffer between the load ports and the travelling rail for the overhead transfer vehicles (see for example JP5229363B). In this apparatus, the cassettes may vertically pass through a gap between a pair of travelling rails for the local vehicle, and the buffer under the travelling rails for the local vehicle allows both the overhead transfer vehicles and the local vehicle to access the cassette.

In addition, stockers for storing the cassettes having a purging function to purge the cassettes by N2 gas, etc. have been known. However, in other places than the stocker, purging is not possible. For example, WO 2014/104895 A1 describes a semiconductor processing assembly having a semiconductor processing system and a substrate cassette stocker with stocker positions, and the stocker may be provided with a purge facility for purging cassettes with an inert gas such as nitrogen. The purge facility may be provided at a position where the cassettes are received in the system, or alternatively one or more stocker positions may be provided with a cassette purge provision.

### SUMMARY OF THE INVENTION

### Problem to be solved by the Invention

When containers are purged with N2 or the like during transfer from one piece of processing equipment to the next piece of processing equipment, problems such as oxidation of the wafer surface are reduced. The purge increases the allowance time for the transfer to the next piece of processing equipment. However, it is not realistic to provide a purging apparatus within processing equipment, since it needs a large-scale remodeling of processing equipment. Therefore, a purging apparatus is necessary in the vicinity of processing equipment.

The object of the invention is to provide an apparatus and a method for more promptly purging containers in the vicinity of a transfer place such as a load port.

This object is achieved by a purging apparatus according to claim 1, and by purging method according to claim 7.

A purging apparatus according to the invention purges containers at a location between overhead transfer vehicles and at least a container transfer place to or from which the containers are transferred, and comprises:
at least a local vehicle configured to travel, the local vehicle provided with a hoist for raising and lowering the containers;
at least a travelling rail for the local vehicle, provided below a travelling rail for the overhead transfer vehicles and above the container transfer place;
a purging table configured to support the containers, provided below the travelling rail for the local vehicle so as not to block a portion over the container transfer place; and
a purging gas feeding device configured to feed a purging gas into the containers supported on the purging table,
wherein the purging table is provided with at least a slide shelf configured to slide between the portion over the container transfer place and a position different from the portion over the container transfer place.

A purging method according to the invention uses a purging apparatus comprising: at least a local vehicle configured to travel and provided with a hoist for raising and lowering containers; at least a travelling rail for the local vehicle, provided below a travelling rail for overhead transfer vehicles and above a container transfer place to or from which containers are transferred; a purging table configured to support the containers, provided below the travelling rail for the local vehicle so as not to block a portion over the container transfer place; and a purging gas feeding device for feeding a purging gas into the containers supported on the purging table, wherein the purging table is provided with at least a slide shelf configured to slide between the portion over the container transfer place and a position different from the portion over the container transfer place, the method comprising: placing the containers temporarily on the purging table at a location between the overhead transfer vehicles and the container transfer place, and purging the containers with the purging gas by the purging gas feeding device.

According to the invention, containers waiting for transfer by the overhead transfer vehicles are purged in the vicinity of a container transfer place. Articles to be accommodated within the containers are semiconductor wafers, foods, medicines, and the like, and purging of containers after the processing of articles reduces problems such as contamination and oxidation of the articles during the wait time for the next processing or the like. When the containers are purged before the processing of the articles, the surface of the articles are made clean in advance. The hoist in the claims corresponds to raising and lowering devices and the like in the embodiments, the container transfer place corresponds to load ports of processing equipment and the like in the embodiments. The purging table corresponds to slide shelves and fixed shelves and the like in the embodiments. With the usage of the slide shelf, the overhead transfer vehicles may transfer the containers between the container transfer place without travelling, and the sliding direction is for example perpendicular to the travelling direction of the local vehicle in a horizontal plane. In this specification, any description concerning the purging apparatus are equally applicable to the purging method.

Preferably, the purging table is further provided with at least a fixed shelf other than the slide shelf, and the controller of the purging apparatus is configured and programmed to control the local vehicle and to select a shelf to support a container from the slide shelf and the fixed shelf in such a way that a container to be transferred to the container transfer place is preferentially purged on the slide shelf to the other containers. The capacity of the purging table is increased by the fixed shelf, and containers to be transferred to the container transfer place are more promptly transferred.

Preferably, the purging apparatus is provided in a ceiling space of a cleanroom and configured to receive the purging gas from a ceiling of the cleanroom. Since installed in the ceiling space, the purging apparatus does not occupy a floor space, and since pipes for the purging gas such as N2 and dry clean air are already often provided in the ceiling, supply of the purging gas is made easy.

Preferably, the containers are cassettes for accommodating semiconductor wafers, and the container transfer place is a load port of semiconductor processing equipment. According to this configuration, the containers are purged before or after the containers are transferred to a load port for processing semiconductor wafers by the processing equipment.

Preferably, the purging table is provided with a fixed part at a position different from the portion over the container transfer place,
the slide shelf is configured to slide between a portion over the fixed part and the portion over the container transfer place,
the purging gas feeding device comprises at least a feeding nozzle provided on the slide shelf for feeding the purging gas into the containers; and a pipe for feeding the purging gas to the feeding nozzle from the fixed part;
the pipe is provided with a bendable portion capable of being bent; and
a cable guide supporting the bendable portion bendably is provided between the slide shelf and the fixed part.

Since the bendable portion is supported by the cable guide, the purging gas is easily supplied to the feeding nozzle on the slide shelf.

Particularly preferably, the slide shelf is provided with a load sensor for detecting a load from a container, and the purging gas feeding device is configured to feed the purging gas through the feeding nozzle, when the load sensor detects a load from a container, and
at least a power line and at least a signal line of the load sensor are supported by the cable guide together with the pipe.

The purging gas is supplied when the load sensor detects the load from a container, and therefore, the purging gas is effectively supplied. Further, the cable guide supports not only the pipe but also the power line and the signal line.

### BRIEF DESCRIPTION OF THE DRAWINGS

[FIG. 1] is a fragmentary front view of the purging apparatus according to an embodiment and surrounding overhead transfer system and a piece of processing equipment.
[FIG. 2] is a fragmentary plan view of the purging apparatus according to the embodiment and processing equipment.
[FIG. 3] is a plan view of a slide shelf in the embodiment.
[FIG. 4] is a plan view of a local vehicle in the embodiment.
[FIG. 5] is a block diagram showing the control system according to the embodiment.
[FIG. 6] is a plan view of the purging apparatus according to a second embodiment.

### DETAILED DESCRIPTION OF THE INVENTION

In the following, the best embodiment for carrying out the invention will be described. The scope of the invention shall be construed according to the claims, with reference to the specification and well-known arts in the field, in accordance with the understandings of a person skilled in the art.

### Embodiment

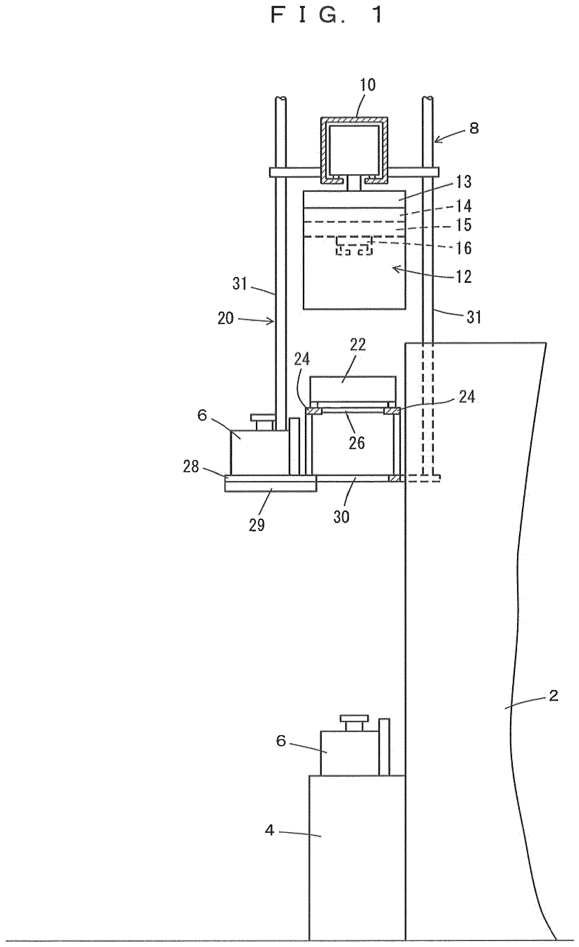

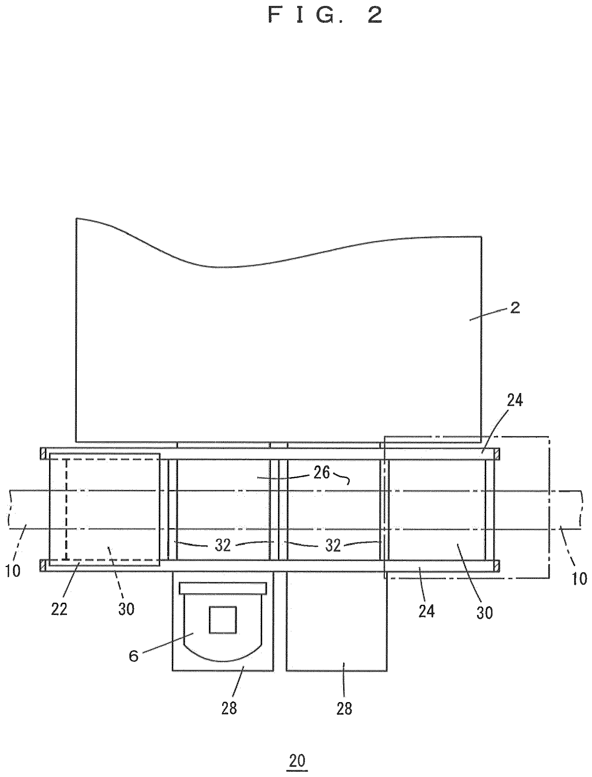

FIGS. 1-6 show the embodiment of the invention and its modifications. FIGS. 1 and 2 show the purging apparatus 20 according to the embodiment, and surrounding processing equipment 2 and an overhead transfer system 8. The processing equipment 2 is provided with load ports 4 which are an example of transfer places of cassettes 6. The processing equipment 2 is not limited to processing apparatuses; it may be an inspection equipment, and the like, and it may be replaced by a storage of empty cassettes or the like. The cassettes 6 may accommodate semiconductor wafers for products, process control wafers, or wafers for inspection purpose and may be empty cassettes. Further, they may accommodate reticles or the like instead of the semiconductor wafers. In the embodiment, we consider that the cassettes 6 are FOUPs (Front Opening Unified Pods).

The overhead transfer system 8 is provided with travelling rail 10 and overhead transfer vehicles 12. The travelling rail 10 passes just over the load ports 4 and is supported from a ceiling of a cleanroom or the like. The overhead transfer vehicles 12 are provided with a lateral movement device and a rotation device 14, and they move a raising and lowering device 15 laterally and also rotate it. The raising and lowering device 15 raises and lowers an elevation platform 16 capable of chucking the cassettes 6.

The purging apparatus 20 is provided with at least a local vehicle 22 and a travelling rail 24 for them. The cassettes may pass vertically through an open space 26 between a pair of rails of the travelling rail 24. Under the travelling rail 24 is a buffer with a purging function. The buffer includes slide shelves 28 just over the load ports 4 and capable of sliding them along the lateral direction in FIG. 1 (the horizontal and perpendicular direction to the longitudinal direction of the travelling rail 24) and includes further, for example, two fixed shelves 30 at positions remote from the load ports 4 in a plan view. Under a slide shelf 28 is a fixed part 29 that accommodates a slide mechanism of the shelf and elements for purging, and the fixed shelves have purging elements (not shown) at their bottoms. The purging apparatus 20 is attached by support rods 31 to the travelling rail 10 of the overhead transfer vehicles 12, however, it may be supported from the ground. Necessary gases and electricity for purging, and the like, are supplied through the support rod 31 or the like from the ceiling of the cleanroom, however, they may be supplied from the ground.

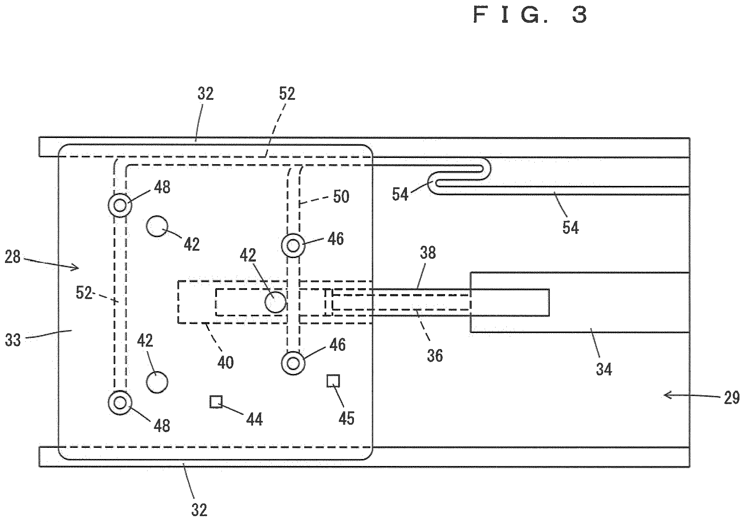

FIG. 3 shows the slide shelf 28, and the slide shelf 28 advances and retracts along a guide 32 relative to the fixed part 29. The mechanism for the sliding is arbitrary, and, for example, a middle part 38 is fixed to a piston 36 engaged in a cylinder 34 which is driven by N2 gas or the like, so that the middle part 38 advances and retracts. Further, double stroke mechanism (not shown) makes a top part 40 advance and retract with a double stroke of the piston 36, and a plate 33 is fixed to the top plate 40 for placing the cassettes.

Three coupling pins 33 are provided on the plate 33 so that they form a triangle and they guide the bottom faces of the cassettes, a seating sensor 44 detects presence or absence of a cassette, and a load sensor 45 detects presence or absence of a load from a cassette. On the plate 33 are for example two feeding nozzles 46, 46 and for example two exhaust nozzles 48, 48, a pipe 50 feeds a purging gas such as N2, and a pipe 52 discharges exhaust gas from a cassette. Bellows making parts of the pipes 50, 52 are attached to a cable guide 54 and they bend together with power and signal lines of sensors 44, 45. Note that the exhaust pipe 48 and the pipe 52 may be omitted.

The pipes 50, 52 may have other bendable portions bendable and may be supported by the cable guide 54 instead of the bellows. The bendable portions may comprise synthetic resin tubes that may be made of a fluoride resin rubber, or a polyester elastomer. The cable guide 54 comprises plural C-shaped elements that are interconnected by pins. The elements are capable of bending around the pins, and within a C-shaped groove are accommodated the pipes 50, 52, signal lines and power lines. The fixed shelves 30 have the same structure with the slide shelves 28 but for the slide mechanism such as the cylinder 34 and the cable guide 54.

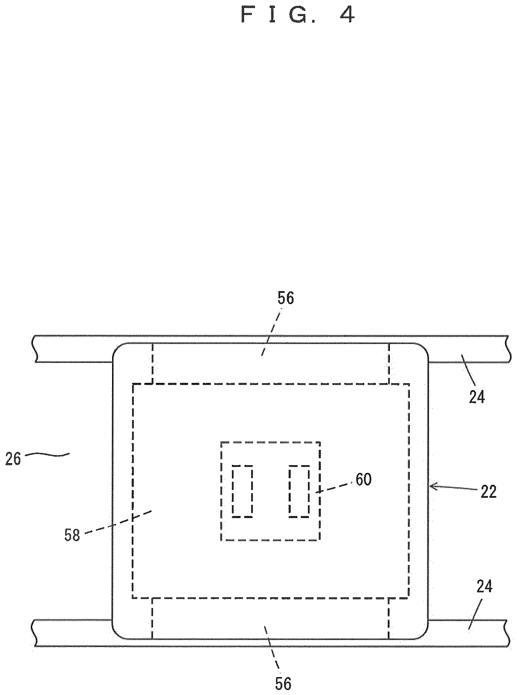

FIG. 4 shows the local vehicle 22; it has, for example, a pair of travelling units 56 and a raising and lowering device 58, and raises and lowers an elevation platform 60 having a chuck by the raising and lowering device 58 so as to transfer cassettes between the load ports and shelves 28, 30.

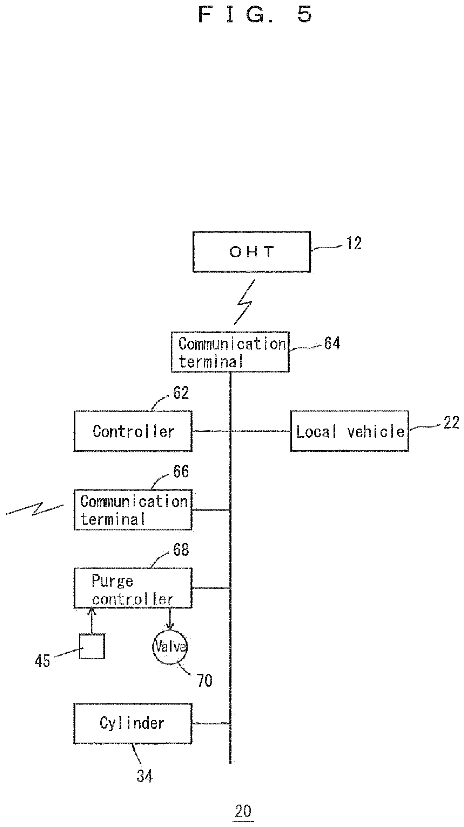

FIG. 5 shows the control system of the purging apparatus 20; a controller 62 controls the purging apparatus 20, and a communication terminal 64 communicates with the overhead transfer vehicles 12 in order to prevent interferences between the local vehicle 22 and the overhead transfer vehicles 12. A communication terminal 66 communicates with a host controller (not shown) and receives instructions regarding transfers within the purging apparatus 20 and regarding the necessity or unnecessity of purging for each cassette. According to the instructions from the controller 62, when the load sensor 45 detects a cassette placed on a slide shelf in a condition suitable for purging, then the purge controller 68 opens a solenoid valve 70 provided in a pipe from the ceiling for N2 gas (purging gas) and feeds the purging gas to the feeding nozzles. Further, according to the instructions from the controller 62, the local vehicle 22 and the cylinder 34 operate.

The operation of the embodiment is now described. Cassettes 6 are transferred from the overhead transfer vehicles 12 or from the load ports 4 on the shelves 28, 30 and they are purged with N2 gas or the like in their internal spaces. When the load sensor 45 detects that a cassette is placed at a correct position, the feeding nozzles 46 feed the purging gas, and the exhaust nozzles 48 discharge. As a result, the atmosphere in the cassette is substituted by the purging gas, and oxidation and contamination of semiconductor wafers are prevented. When the purging is made after processing in the processing equipment 2, if a long period is elapsed before arriving at the next processing equipment or the like, the production quality of semiconductors is far less affected. When an already purged cassette 6 is introduced into processing equipment 2, the surface of the semiconductor wafers are made clean in advance to the introduction into the processing equipment 2, and the amount of atmosphere introduced into the processing equipment 2 is made smaller. Further, regarding empty cassettes, the inside of the cassettes 6 may be cleaned by the purging. Note that the cassettes 6 have valves which are not shown, and the valves open by the pressure from the nozzles 46, 48 and close if the pressure is lost so that the cassettes become airtight.

The slide shelves 28 are provided so that they may advance just over the load ports 4, and therefore, loading to the load ports 4 may be done promptly. Further, they may be provided at positions abutting the load ports 4, the number of shelves per unit length of the travelling rail 24 is increased. Loading from a fixed shelf 30 needs both the travelling of the local vehicle 22 and the loading operation, however, loading from a slide shelf 28 does not need the travelling of the local vehicle 22. Namely, when the local vehicle 22 chucks a cassette 6, the slide shelf 28 retracts sideways promptly, and the local vehicle 22 may start the loading without travelling from the spot. Therefore, if cassettes to be loaded to the load ports 4 are stored on the slide shelves 28, the loading of the cassettes 6 to the load ports 4 is more promptly performed.

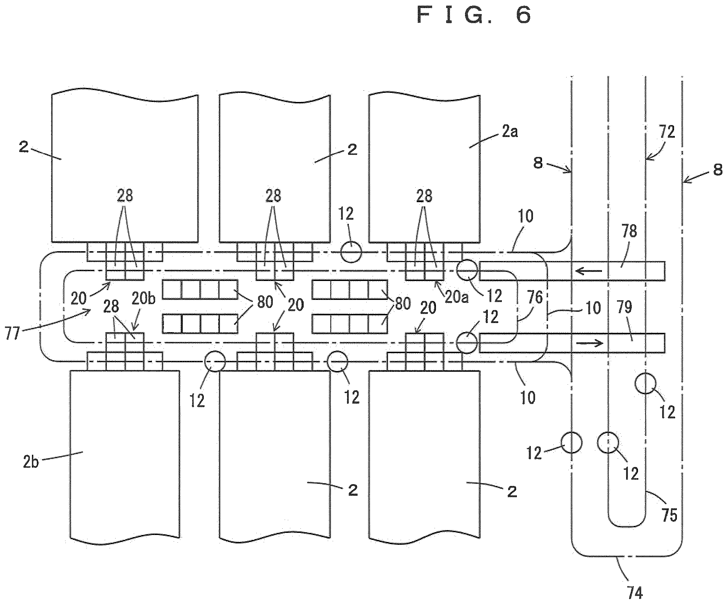

FIG. 6 shows a second embodiment; the same symbols with FIGS. 1-5 represent the same elements, and it is similar to the first embodiment shown in FIGS. 1-5 but for the subsequently indicated points. In addition to the above overhead transfer system 8, another overhead transfer system 72 for transferring cassettes having special attributes in production control such as a hot-lot is provided. Respective travelling rails 74, 75 for the overhead transfer systems 8, 72 are arranged in parallel in an interbay route. If the overhead transfer vehicles 12 may directly enter into a bay 77 from the travelling rail 75 of the overhead transfer system 72, then, complex diverging and merging are necessary in the travelling rails. Therefore, conveyors 78, 79 are provided so that they pass below travelling rails 74, 75, 10, the conveyor 78 is used to transport into the bay 77, and the conveyor 79 is used to transport to the overhead transfer system 72 out of the bay 77. In the bay 77, a loop-like travelling rail 76 that passes over slide shelves 28 of for example plural purging apparatuses 20 is provided so that transfer vehicles such as the overhead transfer vehicles 12 may travel along it, and the slide shelves 28, the conveyors 78, 79, and the overhead transfer system 72 are mutually connected. Further, buffers 80 are provided, and the overhead transfer vehicles 12 travelling along the travelling rail 76 transfer cassettes between the buffers 80 by the lateral movement device 13 in FIG. 1. The buffers 80 may be provided with the purge function with the usage of N2 gas or not.

The overhead transfer vehicles 12 travelling along the travelling rail 76 and the overhead transfer system 72 transfer cassettes such as those accommodating hot-lot wafers for emergent or priority transfer, empty cassettes, and cassettes accommodating process control wafers or wafers for inspection purpose. These cassettes are called cassettes having special attributes in production control. The conveyors 78, 79 connect the overhead transfer system 72 in the interbay route and overhead transfer vehicles travelling the travelling rail 76 in the bay 77. Further, a system comprising the travelling rail 76 and the overhead transfer vehicles 12 may be replaced by an arbitrary system for transferring cassettes in the ceiling space. For example, a gantry crane which two-dimensionally travels in the bay 77, transfer vehicles which travel on a grid-like rail over the bay 77, or autonomously guided vehicles which do not block the clean air flow in the bay 77, etc. may be used. Note that these systems should be provided at an area higher than the purging apparatus 20.

The embodiment in FIG. 6 makes various purging operations possible, for example, when transferring a cassette from first processing equipment 2a to second processing equipment 2b, the cassette is transferred to a purging apparatus 20b near to the second processing equipment 2b after purging at a purging apparatus 20a near to the first processing equipment 2a and further purged at the purging apparatus 20b, before being processed at the second processing equipment 2b. In addition to the purging apparatus 20, the buffers increase the storage capacity in the bay. And, the overhead transfer system 72, the conveyors 78, 79, and travelling rail 76, or the like compensate the transfer delay due to purging.

Containers to be purged are not limited to the cassettes and are arbitrary, and articles to be accommodated may be medicines, foods, or the like, in addition to the semiconductor wafers.

**Description of Symbols**

| | | | |
|---|---|---|---|
| 2 | processing equipment | 4 | load port |
| 6 | cassette | 8,72 | overhead transfer system |
| 10 | travelling rail | 12 | overhead transfer vehicle |
| 13 | lateral movement device | 14 | rotation device |
| 15 | raising and lowering device | 16 | elevation platform |
| 20 | purging apparatus | 22 | local vehicle |
| 24 | travelling rail | 26 | open space |
| 28 | slide shelf | 29 | fixed part |
| 30 | fixed shelf | 31 | support rod |
| 32 | guide | 33 | plate |
| 34 | cylinder | 36 | piston |
| 38 | middle part | 40 | top part |
| 42 | coupling pin | 44 | seating sensor |
| 45 | load sensor | 46 | feeding nozzle |
| 48 | exhaust nozzle | 50,52 | pipe |
| 54 | cable guide | 56 | travelling unit |
| 58 | raising and lowering device | 60 | elevation platform |
| 62 | controller | 64,66 | communication terminal |
| 68 | purge controller | 70 | solenoid valve |
| 74-76 | travelling rail | 77 | bay |
| 78,79 | conveyor | 80 | buffer |

## Claims

1. A purging apparatus for purging containers (6) at a location between overhead transfer vehicles (12) and at least a container transfer place (4) to or from which the containers (6) are transferred, comprising:
at least a local vehicle (22) configured to travel, local vehicle (22) provided with a hoist (58) for raising and lowering the containers (6);
at least a travelling rail (24) for the local vehicle (22), provided below a travelling rail (10) for the overhead transfer vehicles (12) and above the container transfer place (4);
a purging table (28, 29, 30) configured to support the containers (6), provided below the travelling rail (24) for the local vehicle (22) so as not to block a portion over the container transfer place (4); and
a purging gas feeding device (46, 50) configured to feed a purging gas into the containers (6) supported on the purging table (28, 29, 30),
**characterized in that** said purging table is provided with at least a slide shelf (28) configured to slide between the portion over the container transfer place (4) and a position different from the portion over the container transfer place (4).

2. A purging apparatus according to claim 1, wherein said purging table is further provided with at least a fixed shelf (30) other than said slide shelf (28); and
further comprising a controller (62) configured and programmed to control the local vehicle (22) and to select a shelf to support a container (6) from the slide shelf (28) and the fixed shelf (30) in such a way that a container (6) to be transferred to said container transfer place (4) is preferentially purged on said slide shelf (28).

3. A purging apparatus according to one of claims 1-2, provided in a ceiling space of a cleanroom and configured to receive the purging gas from a ceiling of the cleanroom.

4. A purging apparatus according to one of claims 1-3, wherein said containers (6) are cassettes for accommodating semiconductor wafers, and
wherein said container transfer place (4) is a load port of semiconductor processing equipment (2).

5. A purging apparatus according to claim 1, wherein said purging table is further provided with a fixed part (29) at a position different from the portion over the container transfer place (4),
wherein said slide shelf (28) is configured to slide between a portion over the fixed part (29) and the portion over the container transfer place (4),
wherein said purging gas feeding device comprises at least a feeding nozzle (46) provided on said slide shelf (28) for feeding the purging gas into the containers (6); and a pipe (50) for feeding the purging gas to said feeding nozzle from (46) said fixed part (29);
wherein said pipe (50) is provided with a bendable portion capable of being bent; and
wherein a cable guide (54) supporting said bendable portion bendably is provided between said slide shelf (28) and said fixed part (29).

6. A purging apparatus according to claim 5, wherein said slide shelf (28) is provided with a load sensor (45) for detecting a load from a container (6), and said purging gas feeding device (46, 50) is configured to feed the purging gas through said feeding nozzle, when said load sensor (45) detects a load from a container (6), and
wherein at least a power line and at least a signal line of said load sensor (45) are supported by said cable guide (54) together with said pipe (50).

7. A purging method by means of a purging apparatus comprising:
at least a local vehicle (22) configured to travel and provided with a hoist (58) for raising and lowering containers (6); at least a travelling rail (24) for the local vehicle (22), provided below a travelling rail (10) for overhead transfer vehicles (12) and above a container transfer place (4) to or from which the containers (6) are transferred; a purging table (28, 29, 30) configured to support the containers (6), provided below the travelling rail (24) for the local vehicle (22) so as not to block a portion over the container transfer place (4); and a purging gas feeding device (46, 50) for feeding a purging gas into the containers (6) supported on the purging table (28, 29, 30), wherein said purging table is provided with at least a slide shelf (28) configured to slide between the portion over the container transfer place (4) and a position different from the portion over the container transfer place (4),
said method comprising:
placing the containers (6) temporarily on the purging table (28, 29, 30) at a location between the overhead transfer vehicles (12) and the container transfer place (4), and purging the containers (6) with the purging gas by the purging gas feeding device (46, 50).

## Patentansprüche

1. Eine Spülvorrichtung für Spülbehälter (6) an einer Stelle zwischen Hängetransportträgern (12) und zumindest einem Behältertransportort (4), zu oder von dem die Behälter (6) transportiert werden, die folgende Merkmale aufweist:
zumindest einen lokalen Träger (22), der dazu ausgebildet ist, sich zu bewegen, wobei der lokale Träger (22) mit einem Hebezeug (58) zum Anheben und Absenken der Behälter (6) versehen ist;
zumindest eine Bewegungsschiene (24) für den lokalen Träger (22), die unterhalb einer Bewegungsschiene (10) für die Hängetransportträger (12) und oberhalb des Behältertransportorts (4) vorgesehen ist;
einen Spültisch (28, 29, 30), der dazu ausgebildet ist, die Behälter (6) zu tragen, der unterhalb der Bewegungsschiene (24) für den lokalen Träger (22) so vorgesehen ist, dass er einen Abschnitt über dem Behältertransportort (4) nicht blockiert; und
ein Spülgaszuführelement (46, 50), das dazu ausgebildet ist, ein Spülgas in die Behälter (6) zuzuführen, die auf dem Spültisch (28, 29, 30) getragen werden,
**dadurch gekennzeichnet, dass**
der Spültisch mit zumindest einer Gleitablage (28) versehen ist, die dazu ausgebildet ist, zwischen dem Abschnitt über dem Behältertransportort (4) und einer anderen Position als dem Abschnitt über dem Behältertransportort (4) zu gleiten.

2. Eine Spülvorrichtung gemäß Anspruch 1, bei der der Spültisch ferner mit zumindest einer fixierten Ablage (30) versehen ist, die nicht die Gleitablage (28) ist; und
ferner mit einer Steuerung (62), die dazu ausgebildet und programmiert ist, den lokalen Träger (22) zu steuern und eine Ablage auszuwählen, um einen Behälter (6) zu tragen, aus der Gleitablage (28) und der fixierten Ablage (30), auf derartige Weise, dass ein Behälter (6), der zu dem Behältertransportort (4) transportiert werden soll, vorzugsweise auf der Gleitablage (28) gespült wird.

3. Eine Spülvorrichtung gemäß einem der Ansprüche 1-2, die in einem Deckenraum eines Reinraums vorgesehen ist und dazu ausgebildet ist, das Spülgas von einer Decke des Reinraums aufzunehmen.

4. Eine Spülvorrichtung gemäß einem der Ansprüche 1-3, bei der die Behälter (6) Kassetten zum Unterbringen von Halbleiterwafern sind, und
wobei der Behältertransportort (4) eine Ladeöffnung einer Halbleiterverarbeitungsausstattung (2) ist.

5. Eine Spülvorrichtung gemäß Anspruch 1, bei der der Spültisch ferner mit einem fixierten Teil (29) an einer anderen Position als dem Abschnitt über dem Behältertransportort (4) versehen ist,
wobei die Gleitablage (28) dazu ausgebildet ist, zwischen einem Abschnitt über dem fixierten Teil (29) und dem Abschnitt über dem Behältertransportort (4) zu gleiten,
wobei das Spülgaszuführelement zumindest eine Zuführdüse (46), die an der Gleitablage (28) vorgesehen ist, zum Zuführen des Spülgases in die Behälter (6); und ein Rohr (50) zum Zuführen des Spülgases von dem fixierten Teil (29) zu der Zuführdüse (46) aufweist;
wobei das Rohr (50) mit einem biegbaren Abschnitt versehen ist, der gebogen werden kann; und
wobei eine Kabelführung (54), die den biegbaren Abschnitt biegbar trägt, zwischen der Gleitablage (28) und dem fixierten Teil (29) vorgesehen ist.

6. Eine Spülvorrichtung gemäß Anspruch 5, bei der die Gleitablage (28) mit einem Ladesensor (45) zum Erfassen einer Beladung von einem Behälter (6) versehen ist und das Spülgaszuführelement (46, 50) dazu ausgebildet ist, das Spülgas durch die Zuführdüse zuzuführen, wenn der Ladesensor (45) eine Beladung von einem Behälter (6) erfasst, und
wobei zumindest eine Stromleitung und zumindest eine Signalleitung des Ladesensors (45) durch die Kabelführung (54) zusammen mit dem Rohr (50) getragen werden.

7. Ein Spülverfahren mittels einer Spülvorrichtung, die folgende Merkmale aufweist:
zumindest einen lokalen Träger (22), der dazu ausgebildet ist, sich zu bewegen, und der mit einem Hebezeug (58) zum Anheben und Absenken von Behältern (6) versehen ist; zumindest eine Bewegungsschiene (24) für den lokalen Träger (22), die unterhalb einer Bewegungsschiene (10) für Hängetransportträger (12) und oberhalb eines Behältertransportorts (4) vorgesehen ist, zu oder von dem die Behälter (6) transportiert werden; einen Spültisch (28, 29, 30), der dazu ausgebildet ist, die Behälter (6) zu tragen, der unterhalb der Bewegungsschiene (24) für den lokalen Träger (22) so vorgesehen ist, dass er einen Abschnitt über dem Behältertransportort (4) nicht blockiert; und ein Spülgaszuführelement (46, 50) zum Zuführen eines Spülgases in die Behälter (6), die auf dem Spültisch (28, 29, 30) getragen werden, wobei der Spültisch mit zumindest einer Gleitablage (28) versehen ist, die dazu ausgebildet ist, zwischen dem Abschnitt über dem Behältertransportort (4) und einer anderen Position als dem Abschnitt über dem Behältertransportort (4) zu gleiten,
wobei das Verfahren folgende Schritte aufweist:
zeitweiliges Platzieren der Behälter (6) auf dem Spültisch (28, 29, 30) an einer Stelle zwischen den Hängetransportträgern (12) und dem Behältertransportort (4) und Spülen der Behälter (6) mit dem Spülgas durch das Spülgaszuführelement (46, 50).

## Revendications

1. Appareil de purge pour purger des conteneurs (6) à un emplacement entre des véhicules de transfert aériens (12) et au moins un lieu de transfert de conteneurs (4) vers lequel ou à partir duquel sont transférés les conteneurs (6), comprenant:
au moins un véhicule local (22) configuré pour se déplacer, véhicule local (22) pourvu d'un élévateur (58) destiné à lever et abaisser les conteneurs (6);
au moins un rail de déplacement (24) pour le véhicule local (22), prévu au-dessous d'un rail de déplacement (10) pour les véhicules de transfert aériens (12) et au-dessus du lieu de transfert de conteneurs (4);
une table de purge (28, 29, 30) configurée pour supporter les conteneurs (6), prévue au-dessous du rail de déplacement (24) pour le véhicule local (22) de manière à ne pas bloquer une partie au-dessus du lieu de transfert de conteneurs (4); et
un dispositif d'alimentation de gaz de purge (46, 50) configuré pour alimenter un gaz de purge vers les conteneurs (6) supportés sur la table de purge (28, 29, 30),
**caractérisé par le fait que**
ladite table de purge est pourvue d'au moins une étagère coulissante (28) configurée pour coulisser entre la partie au-dessus du lieu de transfert de conteneurs (4) et une position différente de la partie au-dessus du lieu de transfert de conteneurs (4).

2. Appareil de purge selon la revendication 1, dans lequel ladite table de purge est par ailleurs pourvue d'au moins une étagère fixe (30) autre que ladite étagère coulissante (28); et
comprenant par ailleurs un moyen de commande (62) configuré et programmé pour commander le véhicule local (22) et pour sélectionner une étagère pour supporter un conteneur (6) parmi l'étagère coulissante (28) et l'étagère fixe (30) de sorte qu'un conteneur (6) à transférer vers ledit lieu de transfert de conteneurs (4) soit de préférence purgé sur ladite étagère coulissante (28).

3. Appareil de purge selon l'une des revendications 1 à 2, prévu dans un espace de plafond d'une salle blanche et configuré pour recevoir le gaz de purge d'un plafond de la salle blanche.

4. Appareil de purge selon l'une des revendications 1 à 3, dans lequel lesdits conteneurs (6) sont des cassettes destinées à recevoir des plaquettes semi-conducteurs, et
dans lequel ledit lieu de transfert de conteneurs (4) est un orifice de chargement d'un équipement de traitement de semi-conducteurs (2).

5. Appareil de purge selon la revendication 1, dans lequel ladite table de purge est par ailleurs pourvue d'une partie fixe (29) à une position différente de la partie au-dessus du lieu de transfert de conteneurs (4),
dans lequel ladite étagère coulissante (28) est configurée pour coulisser entre une partie au-dessus de la partie fixe (29) et la partie au-dessus du lieu de transfert de conteneurs (4),
dans lequel ledit dispositif d'alimentation de gaz de purge comprend au moins une buse d'alimentation (46) prévue sur ladite étagère coulissante (28) pour alimenter le gaz de purge vers les conteneurs (6); et un tuyau (50) pour alimenter le gaz de purge vers ladite buse d'alimentation (46) depuis ladite partie fixe (29);
dans lequel ledit tuyau (50) est pourvu d'une partie pliable à même d'être pliée; et
dans lequel un guide-câble (54) supportant ladite partie pliable de manière pliable est prévu entre ladite étagère coulissante (28) et ladite partie fixe (29).

6. Appareil de purge selon la revendication 5, dans lequel ladite étagère coulissante (28) est pourvue d'un capteur de charge (45) destiné à détecter une charge d'un conteneur (6), et ledit dispositif d'alimentation de gaz de purge (46, 50) est configuré pour alimenter le gaz de purge à travers ladite buse d'alimentation lorsque ledit capteur de charge (45) détecte une charge d'un conteneur (6), et
dans lequel au moins une ligne de courant et au moins une ligne de signal dudit capteur de charge (45) sont supportées par ledit guide-câble (54) ensemble avec ledit tuyau (50).

7. Procédé de purge au moyen d'un appareil de purge comprenant:
au moins un véhicule local (22) configuré pour se déplacer et pourvu d'un élévateur (58) destiné à lever et abaisser des conteneurs (6); au moins un rail de déplacement (24) pour le véhicule local (22), prévu sous un rail de déplacement (10) pour des véhicules de transfert aériens (12) et au-dessus d'un lieu de transfert de conteneurs (4) vers lequel ou à partir duquel sont transférés les conteneurs (6); une table de purge (28, 29, 30) configurée pour supporter les conteneurs (6), prévue au-dessous du rail de déplacement (24) pour le véhicule local (22) de manière à ne pas bloquer une partie au-dessus du lieu de transfert de conteneurs (4); et un dispositif d'alimentation de gaz de purge (46, 50) destiné à alimenter un gaz de purge vers les conteneurs (6) supportés sur la table de purge (28, 29, 30), où ladite table de purge est pourvue d'au moins une étagère coulissante (28) configurée pour glisser entre la partie au-dessus du lieu de transfert de conteneurs (4) et une position différente de la partie au-dessus du lieu de transfert de conteneurs (4),
ledit procédé comprenant le fait de:
placer les conteneurs (6) temporairement sur la table de purge (28, 29, 30) à un emplacement entre les véhicules de transfert aériens (12) et le lieu de transfert de conteneurs (4), et purger les conteneurs (6) par le gaz de purge par le dispositif d'alimentation de gaz de purge (46, 50).
